# EUROPEAN PATENT APPLICATION

(11) **EP 4 576 450 A1**
(43) Date of publication of application: **25.06.2025**
(21) Application number: 23849545.1
(22) Date of filing: 04.08.2023
(51) Int. Cl.: H01R 13/719

(54) **POWER SUPPLY TERMINAL STRUCTURE AND POWER SUPPLY INTERFACE**

(30) Priority: 05.08.2022 CN 202210936595; 05.08.2022 CN 202222054123 U
(71) Applicant: Shanghai Valeo Automotive Electrical Systems Co., Ltd., Shanghai 201201 (CN)
(72) Inventor: JIN, Ying, Shanghai 201201 (CN); LI, Jianping, Shanghai 201201 (CN)
(74) Representative: Valeo Powertrain Systems
(86) International application number: PCT/CN2023/111332
(87) International publication number: WO 2024/027841

(57) **Abstract**

The present disclosure relates to the field of power interface technology, specifically disclosing a power terminal structure and a power interface. The power terminal structure comprises a housing, a positive electrode, a negative electrode, and a filter capacitor, wherein the positive electrode and the negative electrode are located inside the housing; one end of the positive electrode is protrusively provided with a first connection part, one end of the negative electrode is protrusively provided with a second connection part, the positive electrode and the negative electrode are adjacent to each other, and the filter capacitor is arranged between the positive electrode and the negative electrode, wherein the filter capacitor is connected to the positive electrode by the first connection part, and the filter capacitor is connected to the negative electrode by the second connection part. **In** the present disclosure, the filter capacitor is located near the positive electrode and the negative electrode to improve the filtering effect and anti-magnetic interference ability of the power supply end.

## Description

### TECHNICAL FIELD

The present disclosure relates to the field of power interface technology, in particular to a power terminal structure and a power interface.

### BACKGROUND

A power interface is a device that connects an appliance, for example, an electrical appliance, to a power source. A power interface is internally provided with a filter capacitor, which enables the power interface to have anti-magnetic interference ability for proper operation in an electromagnetic environment.

In the prior art, a filter capacitor is arranged on a PCB (printed circuit board) of a power interface, so the filter capacitor is far away from the positive and negative electrodes of the power interface, and its filtering effect and anti-magnetic interference ability are poor, which will affect normal use of the power interface.

### SUMMARY OF THE DISCLOSURE

An objective of the present disclosure is to provide a power terminal structure and a power interface, so that the filtering effect and anti-magnetic interference ability of a power terminal may be improved by adding a filter capacitor to the power terminal structure.

To achieve the above-mentioned purpose, the present disclosure uses the following technical solution:
In one aspect, the present disclosure provides a power terminal structure, which comprises a housing and
a positive electrode and a negative electrode, wherein both the positive electrode and the negative electrode are located inside the housing; the positive electrode and the negative electrode are adjacent to each other; one end of the positive electrode is protrusively provided with a first connection part, and one end of the negative electrode is protrusively provided with a second connection part;
a filter capacitor arranged between the positive electrode and the negative electrode; the filter capacitor is connected to the positive electrode by the first connection part, and the filter capacitor is connected to the negative electrode by the second connection part.

As an optional solution to the power terminal structure described above, the power terminal structure further comprises a common-mode magnetic ring arranged on the housing; the positive electrode is protrusively provided with a first conductive part, the negative electrode is protrusively provided with a second conductive part, and both the first and second conductive parts can extend out of the housing to pass through the inner ring of the common-mode magnetic ring.

As an optional solution to the power terminal structure described above, a plurality of filter capacitors are arranged, and the plurality of filter capacitors are sequentially connected in series; the outermost two filter capacitors among the plurality of filter capacitors are connected to the first connection part and the second connection part, respectively.

As an optional solution to the above power terminal structure, any two of the above filter capacitors are arranged to cross each other.

As an optional solution to the power terminal structure described above, the power terminal structure further comprises a connector, and two adjacent filter capacitors are connected by the connector.

As an optional solution to the power terminal structure described above, the filter capacitor is provided with a pin which can be welded into the first connection part, the second connection part, and the connector.

As an optional solution to the power terminal structure described above, the outer part of the housing is provided with a groove, and the first connection part, the second connection part, and the filter capacitor can all extend out of the housing to be arranged in the groove; the power terminal structure further comprises a potting filler for potting the groove.

As an optional solution to the power terminal structure described above, the housing is integrally molded by injection molding.

As an optional solution to the power terminal structure described above, the positive electrode, the negative electrode, and the filter capacitor are all injection-molded into the housing.

In another aspect, the present disclosure provides a power interface comprising a power terminal structure as described above.

The present disclosure has the following beneficial effects:
The power terminal structure comprises a housing, a positive electrode, a negative electrode, and a filter capacitor. The positive and negative electrodes are both mounted inside the housing to be protected from erosion by external air, impurities, or other substances. One end of the positive electrode is protrusively provided with a first connection part, one end of the negative electrode is protrusively provided with a second connection part, the positive electrode and the negative electrode are adjacent to each other, the filter capacitor is arranged between the positive electrode and the negative electrode, the filter capacitor is connected to the positive electrode by the first connection part, and the filter capacitor is connected to the negative electrode by the second connection part, so the filter capacitor is located near the positive electrode and the negative electrode to improve the filtering effect and anti-magnetic interference ability of the power supply end.

### BRIEF DESCRIPTION OF THE DRAWINGS

Fig. 1 is a structural schematic diagram of the power terminal structure provided in an embodiment of the present disclosure;
Fig. 2 is a structural schematic diagram of the interior of the power terminal structure provided by an embodiment of the present disclosure;
Fig. 3 is a partially enlarged view of A in Fig. 2; and
Fig. 4 is a structural schematic diagram of part of the power supply terminal structure provided in an embodiment of the present disclosure.

In the figures:
1. housing; 11. groove; 12. limit column; 2. positive electrode; 21. first connection part; 22. first conductive part; 3. negative electrode; 31. second connection part; 32. second conductive part; 4. filter capacitor; 41. pin; 5. connector; 6. common-mode magnetic ring; 7. potting filler.

### DESCRIPTION OF THE EMBODIMENTS

Technical solutions of the present disclosure will be clearly and completely described below in conjunction with the drawings, and, obviously, the described embodiments are only some, but not all, embodiments of the present disclosure. Any embodiments obtained by those of ordinary skill in the art on the basis of the described embodiments of the present disclosure without making inventive efforts fall within the protection scope of the present disclosure.

It should be noted that in the description of the present disclosure, orientations or positional relationships indicated by terms such as "central", "upper", "lower", "left", "right", "vertical", "horizontal", "inside", and "outside" are usually based on the orientations or positional relationships shown in the drawings, are only intended for convenience of describing the present disclosure and brevity of description, rather than indicating or implying that the device or element referred to must have a specific orientation or be constructed and operated in a specific orientation, and therefore should not be understood as a limitation of the protection scope of the present disclosure. In addition, use of terms "first", "second", etc., is only descriptive and should not be considered as indicating or implying relative importance. The terms "first position" and "second position" refer to two different positions, and a first feature being "on", "over", and "above" a second feature includes the first feature being directly above and obliquely above the second feature, or only indicates that the first feature has a horizontal height greater than that of the second feature. A first feature being "under", "beneath", and "below" a second feature includes the first feature being directly below and obliquely below the second feature, or only indicates that the first feature has a horizontal height smaller than that of the second feature.

Note that in the description of the present disclosure, unless otherwise expressly specified or limited, terms "mounting", "connected", and "connection" should be understood in a broad sense, which, for example, may be a fixed connection, a detachable connection, or an integrated connection; a mechanical connection or an electrical connection; a direct connection, an indirect connection through an intermediate medium, or a connection inside two elements. Those of ordinary skill in the art may understand the specific meanings of the above-mentioned terms in the present disclosure as the case may be.

Embodiments of the present disclosure will be described in detail below, and examples of the described embodiments are illustrated by the drawings, in which the same or similar reference signs denote the same or similar components or components having the same or similar functions throughout. The embodiments described below with reference to the drawings are exemplary and only intended to explain the present disclosure and should not be construed as limiting the present disclosure.

This embodiment provides a power terminal structure capable of resisting magnetic interference.

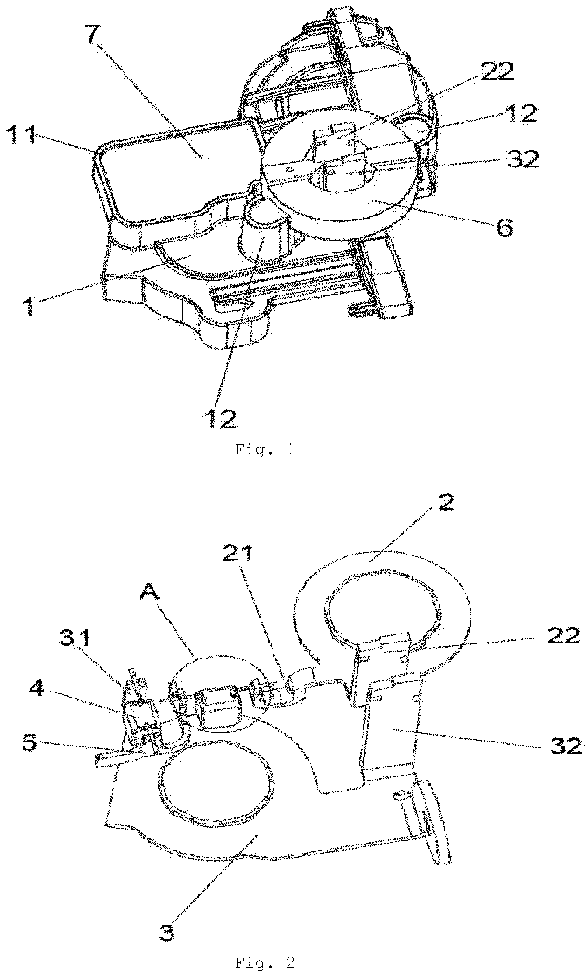

As shown in Figs. 1-4, the power terminal structure comprises a housing 1, a positive electrode 2, a negative electrode 3, and a filter capacitor 4. The positive electrode 2 and the negative electrode 3 are both located inside the housing 1, so that the housing 1 protects the positive electrode 2 and the negative electrode 3 from external air, impurities, and other substances that may corrode the positive electrode 2 and the negative electrode 3.

One end of the positive electrode 2 is protrusively provided with a first connection part 21, one end of the negative electrode 3 is protrusively provided with a second connection part 31, the positive electrode 2 and the negative electrode 3 are adjacent to each other, and a filter capacitor 4 is arranged between the positive electrode 2 and the negative electrode 3, wherein the filter capacitor 4 is connected to the positive electrode 2 by the first connection part 21, and the filter capacitor 4 is connected to the negative electrode 3 by the second connection part 31, so the filter capacitor 4 is located near the positive electrode 2 and the negative electrode 3 to improve the filtering effect and anti-magnetic interference ability of the power supply end. Optionally, the housing 1 is integrally molded by injection molding to improve the structural performance of the power terminal structure so that the housing 1 does not crack after being impacted by a force, and facilitate mass production of the housing 1. Specifically, when the housing 1 is integrally molded by injection molding, the positive electrode 2 and the negative electrode 3 are simultaneously injection-molded into the housing 1.

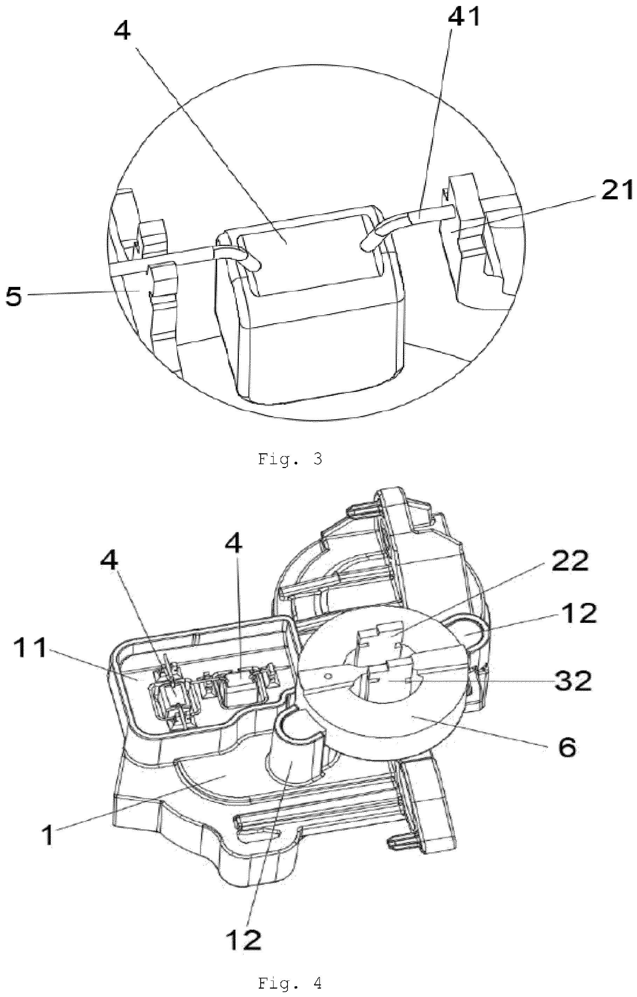

As shown in Fig. 4, the power terminal structure further comprises a common-mode magnetic ring 6 arranged on the housing 1, the positive electrode 2 is protrusively provided with a first conductive part 22, the negative electrode 3 is protrusively provided with a second conductive part 32, and the first conductive part 22 and the second conductive part 32 can both extend out of the housing 1 to pass through the inner ring of the common-mode magnetic ring 6, thereby further improving the anti-magnetic interference ability of the power terminal structure. The first conductive part 22 and the second conductive part 32 may be electrically connected to other components. Specifically, limit columns 12 are arranged on the housing 1, wherein two limit columns 12 are arranged opposite to each other in a horizontal direction on the surface of the housing 1, the common-mode magnetic ring 6 may be clamped between the two limit columns 12 so that the common-mode magnetic ring 6 is limited in a horizontal direction by the two limit columns 12, and, at the same time, the common-mode magnetic ring 6 is bonded to the side wall of the limit column 12 to prevent the common-mode magnetic ring 6 from separating from the housing 1 in a vertical direction.

As shown in Figs. 2-3, a plurality of filter capacitors 4 are provided, wherein the plurality of filter capacitors 4 are sequentially connected in series, and the outermost two filter capacitors 4 among the plurality of filter capacitors 4 are respectively connected to the first connection part 21 and the second connection part 31, so that, by providing a plurality of filter capacitors 4 connected in series, the safety of the power terminal structure may be improved to avoid safety accidents of fire that would otherwise occur if the positive and negative electrodes are short-circuited when the filter capacitor 4 fails if a single filter capacitor 4 is used. Specifically, among a plurality of filter capacitors 4 connected in series, a filter capacitor 4 may fail due to problems such as a capacitor lifespan problem, a capacitor assembly process problem, and a capacitor quality problem, while any filter capacitor 4 that has not failed among the plurality of filter capacitors 4 will perform a direct-current isolation function to protect the power terminal structure.

Further, any two filter capacitors 4 are arranged to cross each other, so that when the power terminal structure is subjected to a vibration or impact, simultaneous failure of a plurality of filter capacitors 4 arranged in the same direction is avoided to reduce safety accidents caused by a failure of the filter capacitors 4. Optionally, two filter capacitors 4 are arranged at an angle of 90° to each other.

Further, the power terminal structure further comprises a connector 5, and two adjacent filter capacitors 4 are connected by the connector 5, which makes it convenient for an operator to connect a plurality of filter capacitors 4 in series. The filter capacitor 4 is provided with a pin 41, and the pin 41 can be welded into the first connection part 21, the second connection part 31, and the connector 5 to improve the stability of the connection of the filter capacitor 4 to the first connection part 21, the second connection part 31, and the connector 5, which prevents the filter capacitor 4 from separating from the first connection part 21, the second connection part 31, and the connector 5 after being subjected to a vibration or impact. In addition, by welding the pin 41 of the filter capacitor 4 into the first connection section 21, the second connection section 31, and the connector 5, the contact resistance between the pin 41 and the first connection section 21, the second connection section 31, and the connector 5, respectively, may be improved to improve the heating condition of the power terminal structure and enhance the anti-magnetic interference ability thereof. Specifically, an operator can first place the pin 41 of the filter capacitor 4 in the placement slot on the first conductive part 22, the second conductive part 32 and the connector 5, and then close the placement slot by a resistance welding hot clamp process, so that the pin 41 of the filter capacitor 4 is welded onto the first conductive part 22, the second conductive part 32, and the connector 5. Optionally, the pin 41 of the filter capacitor 4 may also be positioned on the first conductive part 22, the second conductive part 32, and the connector 5 by processes such as riveting, resistance welding, and laser welding, which is not specifically limited in this embodiment.

Further, the exterior of the housing 1 is provided with a groove 11, and the first connection part 21, the second connection part 31, and the filter capacitor 4 can all extend out of the housing 1 to be arranged in the groove 11, which makes it convenient for an operator to connect the filter capacitor 4 to the first connection part 21 and the second connection part 31, while part of the connector 5 can also extend out of the housing 1 to be arranged in the groove 11, which makes it convenient for an operator to connect a plurality of filter capacitors 4 in series. The power terminal structure further comprises a potting filler 7 for potting the groove 11 to protect the filter capacitor 4 from external air, impurities, and other substances that may corrode the filter capacitor 4, and, after being wrapped around the filter capacitor 4, the potting filler 7 can also contribute to vibration resistance of the filter capacitor 4. Optionally, the potting filler 7 is potting adhesive. Further, optionally, the positive electrode 2, the negative electrode 3, and the filter capacitor 4 are all injection-molded into the housing 1 to simplify the manufacturing process of the power terminal structure, eliminating the need for a potting filler 7 to reduce processing costs. Specifically, before the housing 1 is integrally molded by injection molding, the filter capacitor 4 is first connected to the positive electrode 2 and the negative electrode 3, and then the positive electrode 2, the negative electrode 3, and the filter capacitor 4 are injection-molded into the housing 1.

This embodiment further provides a power interface, which comprises a power terminal structure as described above, and the filtering effect and anti-magnetic interference ability of the power interface are improved by the power terminal structure. Optionally, the power interface is the power supply interface of a 48 V belt starter-generator, which supplies power to a 48 V integrated controller. Of course, the power interface may also be an interface of another device, which is not specifically limited in this embodiment.

Obviously, the above-described embodiments of the present disclosure are only examples provided to clearly explain the present disclosure, rather than limiting embodiments of the present disclosure. Those skilled in the art could make other changes or alterations in various forms on the basis of the explanation above. It is not possible to list all embodiments here exhaustively. Any modifications, substitutions, improvements, etc., made within the spirit and principle of the present disclosure shall be included in the protection scope of the claims of the present disclosure.

## Claims

1. A Power terminal structure, **characterized in that** it comprises a housing (1) and
a positive electrode (2) and a negative electrode (3), wherein the positive electrode (2) and the negative electrode (3) are located inside the housing (1); the positive electrode (2) and the negative electrode (3) are adjacent to each other; one end of the positive electrode (2) is protrusively provided with a first connection part (21), and one end of the negative electrode (3) is protrusively provided with a second connection part (31);
a filter capacitor (4), the filter capacitor (4) being arranged between the positive electrode (2) and the negative electrode (3); the filter capacitor (4) is connected to the positive electrode (2) by the first connection part (21), and the filter capacitor (4) is connected to the negative electrode (3) by the second connection part (31).

2. The power terminal structure according to Claim 1, **characterized in that** the power terminal structure further comprises a common-mode magnetic ring (6) arranged on the housing (1); the positive electrode (2) is protrusively provided with a first conductive part (22), the negative electrode (3) is protrusively provided with a second conductive part (32), the first conductive part (22) and the second conductive part (32) can both extend out of the housing (1) to pass through an inner ring of the common-mode magnetic ring (6).

3. The power terminal structure according to Claim 1, **characterized in that** a plurality of filter capacitors (4) are provided, and the plurality of filter capacitors (4) are sequentially connected in series; the outermost two filter capacitors (4) among the plurality of filter capacitors (4) are connected to the first connection part (21) and the second connection part (31), respectively.

4. The power terminal structure according to Claim 3, **characterized in that** any two of the filter capacitors (4) are arranged to cross each other.

5. The power terminal structure according to Claim 3, **characterized in that** the power terminal structure further comprises a connector (5) and that two adjacent filter capacitors (4) are connected by the connector (5).

6. The power terminal structure according to Claim 5, **characterized in that** the filter capacitor (4) is provided with a pin (41), wherein the pin (41) can be welded into the first connection part (21), the second connection part (31), and the connector (5).

7. The power terminal structure according to Claim 1, **characterized in that** the exterior of the housing (1) is provided with a groove (11), and that the first connection part (21), the second connection part (31), and the filter capacitor (4) can all extend out of the housing (1) to be arranged in the groove (11); the power terminal structure further comprises a potting filler (7) for potting the groove (11).

8. The power terminal structure according to Claim 1, **characterized in that** the housing (1) is integrally molded by injection molding.

9. The power terminal structure according to Claim 8, **characterized in that** the positive electrode (2), the negative electrode (3), and the filter capacitor (4) are all injection-molded into the housing (1).

10. A power interface, **characterized in that** the power interface comprises a power terminal structure according to any one of Claims 1-9.
